# EUROPEAN PATENT APPLICATION

(11) **EP 2 955 494 A1**
(43) Date of publication of application: **16.12.2015**
(21) Application number: 14172076.3
(22) Date of filing: 12.06.2014
(51) Int. Cl.: G01J 1/02, G01J 1/04, G02B 6/42, G01J 1/42, G01J 1/44

(54) **A single-photon camera**

(71) Applicant: Karlsruher Institut für Technologie, 76131 Karlsruhe (DE)
(72) Inventor: Pernice, Wolfram, 76139 Karsruhe (DE)
(74) Representative: Herzog, Fiesser & Partner Patentanwälte PartG mbB

(57) **Abstract**

The present invention relates to a nanophotonic device (112), comprising a transparent substrate (114), wherein at least four grating couplers (120) for receiving incident light are located on the substrate (114), wherein each of at least two of the grating couplers (120) are optically coupled to a superconducting stripe (124) of a superconducting single-photon detector (126), while each of at least two of the other grating couplers (120) constitute an optical reference port (142), wherein an optical coupling (144) is provided between at least two optical reference ports (142).

The present invention further relates to a single-photon camera which comprises a housing (168), wherein the housing (168) comprises a single-photon detector chip (162) with at least one nanophotonic device (112), a method for manufacturing the nanophotonic device (112), and a method for aligning an optical fiber array (138) to the nanophotonic device (112).

## Description

### Field of the invention

The present invention is related to a single-photon camera, more particular, to a nanophotonic device, a single-photon camera comprising a single-photon detector chip with at least one nanophotonic device, a method for manufacturing the nanophotonic device, and a method for aligning an optical fiber array to the nanophotonic device.

### Related art

The present invention is located in the fields of nanophotonics and integrated optics as well as in the fields of superconductivity and fiber optics. The particular object of the present invention addresses urgent needs in providing a plurality of high-efficient superconducting single-photon detectors (SSPDs), in particular, for implementing a one-dimensional or a two-dimensional array for imaging applications, such as with a single-photon camera.

Superconducting single-photon detectors have first been described in G. N. Gol'tsman, O. Okunev, G. Chulkova, A. Lipatov, A. Semenov, K. Smirnov, B. Voronov, A. Dzardanov, C. Williams, and R. Sobolewski, Picosecond superconducting single-photon optical detector, Applied Physics Letters 79, 705-707, 2001. An overview of the state-of-the-art SSPDs can be found in G. Gol'tsman, O. Minaeva, A. Korneev, M. Tarkhov, I. Rubtsova, A. Divochiy, I. Milostnaya, G. Chulkova, N. Kaurova, B. Voronov, D. Pan, J. Kitaygorsky, A. Cross, A. Pearlman, I. Komissarov, W. Slysz, M. Wegrzecki, P. Grabiec, and R. Sobolewski, Middle-Infrared to Visible-Light Ultrafast Superconducting Single-Photon Detectors, IEEE Trancsactions on Applied Superconductivity 17, 246-251, 2007.

Accordingly, known superconducting single-photon detectors are nanostructured devices based on long stripes of an ultra-thin superconducting film, which are operated well below the critical temperature T_{c} of the superconducting material, thereby being biased with a subcritical current. A typical example for a superconducting stripe comprises a narrow (width 100-120 nm) and ultra-thin (film thickness approx. 4 nm) film of a superconducting material, in particular niobium nitride NbₓN, wherein the superconducting stripe has a meander shape covering a 10 µm x 10 µm area with a filling factor as high as 0.6 to 0.7, particularly in order to improve the coupling of the superconducting stripe to incident photons. For the purpose of its operation, the SSPD is maintained at a temperature below the critical temperature T_{c}, preferably below T_{c}/2, and carries a bias current I_{b} below the critical current I_{c}. The single-photon detection mechanism is based on a formation of a resistive region inside the superconducting stripe biased with I_{b} close to I_{c} upon photon absorption. As a result, the SSPD produces a distinct voltage pulse comprising an amplitude of the order of approx. 1 mV, which may be used to detect the presence of a photon.

WO 2014/026724 Al discloses an integrated, hybrid nanophotonic-superconducting device which functions as a scalable spectrometer with single-photon intensity resolution, wherein the device is implemented on a single chip and optically contacted by using optical fibers, thus being compatible with optical imaging systems through a fiber-coupling port.

Currently, however, single-photon detectors are single-pixel units, wherein each unit is housed in an individual system in order to detect a single photon as provided by a single optical input. In addition, known SSPDs are separately connected to optical fibers. Furthermore, the meander shape detectors are illuminated in transmission. Consequently, the state of the art does not provide a solution for a high coupling efficiency for photons which may be transported from a reception which receives an optical fiber to the SSPD. As a result, currently known SSPDs are not scalable since they comprise separate single-pixel units wherein each detector is coupled separately to an optical fiber. Besides sophisticated optical coupling, a desired array which comprises single-pixel units of SSPDs would require a large amount of space, which is, however, usually only available to a rather limited extent within a low-temperature cryostat. Consequently, known SSPDs are generally inappropriate for providing an array of SSPDs for imaging applications which would be suitable for an apparatus such as a single-photon camera.

### Problem to be solved

It is therefore an objective of the present invention to provide a nanophotonic device, a single-photon camera, a method for manufacturing the nanophotonic device, and a method for aligning an optical fiber array to the nanophotonic device in order to overcome the above-mentioned problems and shortcomings of the present state of the art.

### Summary of the invention

This problem is solved by a nanophotonic device, a single-photon camera, a method for manufacturing the nanophotonic device, and a method for aligning an optical fiber array to the nanophotonic device with the features of the independent claims. Preferred embodiments, which might be realized in an isolated fashion or in an arbitrary combination, are listed in the dependent claims.

As used in the following, the terms "have", "comprise" or "include" or any arbitrary grammatical variations thereof are used in a non-exclusive way. Thus, these terms may both refer to a situation in which, besides the feature introduced by these terms, no further features are present in the entity described in this context and to a situation in which one or more further features are present. As an example, the expressions "A has B", "A comprises B" and "A includes B" may both refer to a situation in which, besides B, no other element is present in A (i.e. a situation in which A solely and exclusively consists of B) and to a situation in which, besides B, one or more further elements are present in entity A, such as element C, elements C and D or even further elements.

Further, as used in the following, the terms "preferably", "more preferably", "particularly", "more particularly", "specifically", "more specifically" or similar terms are used in conjunction with optional features, without restricting alternative possibilities. Thus, features introduced by these terms are optional features and are not intended to restrict the scope of the claims in any way. The invention may, as the skilled person will recognize, be performed by using alternative features. Similarly, features introduced by "in an embodiment of the invention" or similar expressions are intended to be optional features, without any restriction regarding alternative embodiments of the invention, without any restrictions regarding the scope of the invention and without any restriction regarding the possibility of combining the features introduced in such way with other optional or non-optional features of the invention.

In a first aspect, the present invention relates to a nanophotonic device. As further used herein, the "nanophotonic device" may refer to an arbitrary device which may be adapted for an application within the field of nanophotonics. Herein, the term "nanophotonics", also denoted as "nano-optics", may usually be employed to describe both the basic research and the industrial applications with regard to light which may interact with structures which may exhibit features with dimensions below the wavelength, in particular below less than half of the wavelength, of the light interacting with the mentioned structure, which may also be denoted as "nanostructure". As further used herein, the term "light" may not be limited to photons with a wavelength with respect to the visible part of the electromagnetic spectrum between 380 nm and 780 nm but may also extend to the adjoining realms of ultra-violet (UV) light between 10 nm and 380 nm, preferably between 200 nm and 380 nm, more preferably between 300 nm and 380 nm, as well as to the realm of infra-red (IR) light with wavelengths between 1 mm and 780 nm, in particular between 3 µm and 780 nm, more particular between 1200 nm and 780 nm. In contrast to classical optics, in nanophotonics the interaction of light with nanostructures may lead to a confinement of the electromagnetic field to the respective nanoscale feature which may result in an evanescent near-field which may particularly occur in the vicinity of the nanostructure.

The nanophotonic device according to the present invention comprises a substrate. As further used herein, the "substrate" may refer to a usually planar body on top of which at least one layer may be placed, in particular for manufacturing a more complex device. With regard to the present invention, the substrate comprises an optically transparent material, preferably glass or quartz, wherein the optically transparent material may exhibit a first refractive index. As used herein, the term "refractive index" may constitute a material constant which may express a response of the material to an incident light beam with respect to a change from a sine of an angle of incidence to the sine of an angle of refraction. For most optically transparent materials, the refractive indices may take a value between 1 and 3, such as for glass or quartz, in which the refractive index takes a value around 1.5 within the visible spectrum.

According to the present invention, at least four grating couplers for receiving incident light are located on the substrate. As further used herein, the term "located on the substrate" may refer to an arrangement wherein an element may be completely located on the top of a substrate, such as a separate layer deposited on top of an area which comprising part of a flat substrate, or wherein a part of the element may be covered by the substrate in a manner that only the remaining part of the element may protrude from the surface of the substrate.

As used herein, the "grating coupler" denotes an arbitrary optical element which is capable of coupling incident light into a further optical structure, such as a nanophotonic waveguide. In particular, the grating coupler comprises a region on top of or below a waveguide which comprises an optical grating. For this purpose, the grating coupler may typically exhibit only a small number of periods, thus, allowing light to be coupled into the optical element, such as the waveguide, connected to it but not back out from the grating coupler. For the purpose of the present invention, a grating coupler comprising a high diffraction efficiency may be preferred. As used herein, the diffraction efficiency may describe the percentage of light which might be coupled into the diffraction grating as comprised within the grating coupler. As will be described below in more detail, the at least four grating couplers required for the present invention may be structured into a wide-bandgap material, preferably together with nanophotonic waveguides for further guiding incident photons from the respective grating coupler to a detector.

According to the present invention, preferably the same type of grating couplers may be applied for two different kinds of purposes. Accordingly, each of at least two of the grating couplers are optically coupled to a superconducting stripe of a superconducting single-photon detector while each of at least two of the other grating couplers constitute an optical reference port. As already described above, the superconducting single-photon detector comprises the superconducting stripe for the purpose of detecting a single photon being received by the superconducting stripe. In contrast to the state of the art, wherein the single photon to be detected by the SSPD is directly coupled into the superconducting stripe, such as by using an optical fiber, according to the present invention, each of the superconducting stripes in the nanophotonic device is optically coupled to a corresponding grating coupler. In a particularly preferred embodiment, the superconducting stripe of the SSPD may, thus, optically be coupled to the respective grating coupler by using the nanophotonic waveguide, such as described above and/or below, wherein the nanophotonic waveguide may be located on the substrate. As described elsewhere, the nanophotonic waveguide which optically couples the superconducting stripe to the respective grating coupler may be structured into the same wide-bandgap material which may be used for the corresponding grating coupler, thus, providing a high coupling efficiency between the grating coupler and the respective superconducting stripe of the SSPD. According to the present invention, the nanophotonic device, therefore, comprises at least two segments, wherein each segment comprises, located on a substrate, a grating coupler and a superconducting stripe, which may be optically coupled by using a nanophotonic waveguide.

As used herein, the term "nanophotonic waveguide" may refer to a structure which may primarily perform a function of guiding a light wave, preferably comprising a single photon, along the nanostructure of the waveguide primarily for its transport. For this purpose, desired waveguiding properties may be achieved by selecting a defined thickness of the waveguiding layer and/or by choosing a specific width of the waveguiding layer which may be provided as a planar waveguide. In a particularly preferred embodiment, wherein an optically transparent substrate material like glass or quartz may exhibit a first refractive index, a thin film of a wide electronic band gap material may be placed on top of the substrate, from which the desired optical elements of the nanophotonic device may be formed. The wide electronic band gap material may particularly be useful in order to enable a broad-band optical transparency within the thin film. With regard to the present invention, the wide electronic band gap material may particularly be selected to comprise a nitride semiconductor, preferably a III-nitride semiconductor, such as silicon nitride or aluminum nitride, or, in a particular case, wherein the nanophotonic device may especially be adapted for a use within the infrared spectral range, to comprise silicon which exhibits the required properties within the infrared spectral range.

According to the present invention, each of at least two of the other grating couplers constitutes an optical reference port, wherein an optical coupling is provided between at least two optical reference ports. As used herein, the "optical reference port" may refer to a further segment of the nanophotonic device which may not comprise a superconducting stripe since it may not be employed for detecting photons as it may be involved for alignment purposes. Thus, in contrast to the at least two of the grating couplers as mentioned above which are optically coupled to the superconducting stripe, at least two of the other grating couplers which each constitute an optical reference port are connected with each other by an optical coupling, wherein the optical coupling between the optical reference ports may preferably be provided by at least one nanophotonic waveguide. Consequently, those grating couplers which constitute an optical reference port are not optically coupled to any one of the superconducting stripes but at least two of them exhibit an optical coupling between two of the optical reference ports. As will be described below in more detail, this feature of the nanophotonic device may particularly be suited for aligning each optical fiber comprised in an array of at least four optical fibers with one of the grating couplers of the nanophotonic device.

In a preferred embodiment, the grating couplers on the substrate may particularly be arranged in an arrangement located on the substrate selected from a first arrangement comprising a one-dimensional matrix and a second arrangement comprising a two-dimensional matrix. According to the first arrangement, at least two of the grating couplers which are optically coupled to the superconducting stripes and at least two of the grating couplers which constitute the optical reference ports may be arranged in a single line as a one-dimensional matrix on top of the substrate. Alternatively, in a second kind of arrangement, at least three of the grating couplers which are optically coupled to the superconducting stripes and at least three of the grating couplers which constitute the optical reference ports may be arranged as a two-dimensional matrix on the substrate, such as a 2 x 3, 4 x 4, 6 x 8, 8 x 8, 16 x 16, 64 x 64, 256 x 256, 512 x 512, 1024 x 1024, or a larger two-dimensional matrix arrangement. Within this regard, it may be particularly preferred, when the grating couplers which constitute the optical reference ports may be located at least one final position in the arrangement, such as the first element and the last element in a one-dimensional row, or the corner elements in a two-dimensional matrix. This kind of arrangement may particularly provide for as little as possible interaction of the optical reference ports with a plurality of the superconducting single-photon detectors within the nanophotonic device. In addition, the plurality of superconducting single-photon detectors may, thus, not be interrupted by an optical reference port within this kind of arrangement.

In a particularly preferred embodiment, both the grating couplers as used for the optical reference ports and the grating couplers as coupled to the superconducting stripes of the SSPDs are preferentially co-fabricated simultaneously on the substrate. For further details within this regard, reference may be made to the description of the method for manufacturing the nanophotonic device as presented below.

In a further preferred embodiment, at least the grating couplers may be covered with a passivation layer, wherein the passivation layer preferably comprises a suitable oxide for passivation of the optical elements as located on top of the substrate. However, the passivation layer may additionally cover the superconducting stripes and/or the nanophotonic waveguides. In addition, the passivation layer may further provide a way for implementing the grating within the grating coupler, in particular, for providing grating couplers with an ultra-high efficiency.

In a further preferred embodiment, a reflecting layer may be placed on the passivation layer in an area located above the grating couplers which are optically coupled to the superconducting stripe. Herein, a thin metallic film which may act as a high-reflectivity mirror may particularly be used, thus, forcing light transmitted through the grating coupler to be reflected back into the grating. As confirmed by respective simulations, the reflecting layer may contribute to increase the coupling efficiency of the grating couplers to a value close to 100%. In addition, the reflecting layer may provide a simple, fault tolerant improvement of the coupling efficiency for the grating couplers at the same time. Furthermore, by controlling the thickness of the passivation layer on top of the substrate, which may be performed with nanometer precision during the deposition, the coupling efficiency of the grating couplers may further be enhanced to a desired level. Also, the passivation layer and/or the reflecting layer may be employed for protecting nanophotonic elements on top of the substrate, in particular the grating couplers, the nanophotonic waveguides and the superconducting stripes, against environmental influence, leading to a chemical inertness and, thus, to a long-term stability of the nanophotonic device according to the present invention.

In a further preferred embodiment, the substrate of the nanophotonic device may additionally comprise a reception for receiving an array of at least four optical fibers, particularly at the bottom of the substrate which may be polished to a desired thickness, for an alignment of the fiber array. By using a suitable material, such as glass or quartz, as the transparent substrate, the substrate may, thus, be index-matched as an optical input port for light provided by the fibers of the fiber array and, therefore, little or no back-reflection from the fibers may occur. For this purpose, the fiber array may be polished under a particular angle, thus, being optimized for providing a high-coupling efficiency of the light provided by the fibers into the grating couplers. Advantageously, glass fibers may be used for this purpose since an entire two-dimensional fiber matrix may be heat-pulled if a smaller diameter of the fibers may be required. In addition, since the diameter of the fibers is determined by both the cladding and the core of the fibers, the area as provided by each fiber may be sufficiently large to provide generous space for the grating coupler and the adjacent waveguide within the nanophotonic device.

Consequently, the nanophotonic device may be able to provide a method of operation according to the following manner. Single photons may be provided by the fiber array which comprises a high density, multi-channel optical input for the single photons into the present nanophotonic device. An incident photon may be guided from the respective optical fiber via the transparent substrate into one of the grating couplers which are coupled to the superconducting stripes, preferably by the corresponding nanophotonic waveguide. As described above, the single photon may, thus, be guided into the superconducting stripe, wherein it may form a resistive region, which, finally, may produce a distinct voltage that may be recorded and evaluated in a suitable evaluation unit. Since the nanophotonic device according to the present invention comprises at least two grating couplers, preferably a multitude of grating couplers, more preferably a plurality of grating couplers, which each are optically coupled to a superconducting stripe, it may be able to provide for a one-dimensional or a two-dimensional multi-pixel image of single photon counts as provided by the optical fiber array and may, thus, function as a single-photon camera.

In a further aspect, the present invention relates to a single-photon camera, which comprises a housing, wherein the housing at least comprises at least one single-photon detector chip, where the single-photon detector chip comprises at least one nanophotonic device as described above and/or below. As further used herein, the term "housing" may refer to an arbitrary cover which may at least partially surround the at least one single-photon detector chip in order to provide input and/or output ports to the nanophotonic device as well as an environmental protection for the single-photon detector chip and any other units as comprised within the housing. In addition, the housing may particularly be configured for protecting the single-photon detector chip from stray light which may otherwise produce undesired results within the SSPDs of the nanophotonic device. Furthermore, since the SSPDs usually require a cool environment, the housing may further comprise a low-temperature cryostat or may be configured in a manner to be inserted into such a cryostat.

In addition, the single-photon detector chip further comprises a reception in order to align each of the optical fibers of an array of at least four optical fibers with one of the grating couplers of the nanophotonic device. Within this regard, the optical fiber array may, thus, function as an input port for providing incident photons to the SSPDs within the nanophotonic device. Moreover, the housing may comprise an output port, such as an output fiber array which may, within a first regard, be used to serve as a multi-port optical terminal or, within a second regard, to provide an input to an imaging optics. Within the first regard, each output optical fiber may be employed as an individual detector which may comprise negligible dark counts, a high count rate, high efficiency and a very high timing resolution. Herein, the number of optical fibers may not be limited by the arrangement of the single-photon detector chip according to the present invention and may, thus, be targeted to customer needs. Within the second regard, the output fiber array may be bundled into a single-optical access port which may be connected to an imaging system. Such an approach may also be employed for remote imaging by using the fiber array in areas with restricted access, such as narrow pipes or harsh environments. In addition, since optical fibers may be heat-pulled, the diameters of the input optical fibers may further be reduced if required.

In a further aspect, the present invention relates to a method for manufacturing a nanophotonic device, in particular the nanophotonic device as described above and/or below. The method for manufacturing the nanophotonic device according to the present invention comprises at least the following steps (a) to step (e), wherein, however, additional steps may further be performed. Preferably, the method steps (a) to (e) may be performed in the given order, commencing with step (a), continuing with steps (b), (c) and (d) in this order, and finishing with step (e), wherein, however, a subsequent step may partially be performed concurrently with a previous step.

For further details concerning the various methods according to the present invention, reference may be made to the description of the nanophotonic device and/or the integrated optical circuit as comprised above and/or below.

According to step (a) of the present invention, a transparent substrate as described above and/or below is provided.

According to step (b) of the present invention, a film of a wide-bandgap material, in particular of silicon, gallium nitrite, or aluminum nitrite, is deposited onto the mentioned substrate. Within this regard, it is preferably advantageous to provide a transparent substrate, such as glass or quartz, which may exhibit a lower refractive index with respect to the wide-bandgap material in order to tightly confine light within nanostructures introduced into the wide-bandgap material below the diffraction limit. Preferably, the thickness of the wide-bandgap material film may be significantly below the free-space optical wavelength of the incident light in order to guarantee sufficient evanescent fields on top of the surface of a waveguide as being structured into the respective film.

According to step (c) of the present invention, a superconducting film, which may particularly comprise a niobium nitrite NbₓN, is placed on a part of the wide-bandgap material in a form of a superconducting stripe being configured for working as an active element within a superconducting single-photon detector as described above.

According to step (d) of the present invention, at least four grating couplers as described above are structured into the wide-bandgap material outside the area where the superconducting film is placed on the wide-bandgap material. Herein, at least two of the grating couplers are structured in a manner that each of them are optically coupled to the superconducting stripe in order to provide incident photons to the superconducting stripe, in particular by using a further nanophotonic waveguide which may, preferably simultaneously, be structured into the wide-bandgap material.

According to step (e) of the present invention, an optical coupling between at least two of the other grating couplers is provided, wherein each of the at least two other grating couplers constitute an optical reference port. In a preferred embodiment, at least one nanophotonic waveguide as described above and/or below may be provided for the optical coupling between the respective optical reference ports.

In addition, the present method for manufacturing the nanophotonic device may comprise further steps, such as depositing a passivation layer for covering at least the grating couplers and/or for placing a reflecting layer on the passivation layer in an area located above the grating couplers which are optically coupled to the superconducting stripe. For further details with regard to these additional steps, reference may be made to the description of the nanophotonic device as presented above and/or below.

In a further aspect, the present invention relates to a method for aligning an optical fiber array to a nanophotonic device, in particular to the nanophotonic device as described above and/or below. The method for aligning an optical fiber array to the nanophotonic device according to the present invention comprises at least the following steps (f) to step (i), wherein, however, additional steps may further be performed. Preferably, the method steps (f) to (i) may be performed in the given order, commencing with step (f), continuing with steps (g) and (h) in this order, and finishing with step (i), wherein, however, a subsequent step may partially be performed concurrently with a previous step.

According to step (f) of the method for aligning an optical fiber array to a nanophotonic device, the array of the optical fibers, which comprises at least four optical fibers arranged as a single bundle, is provided for a respective reception at a substrate of the nanophotonic device. Within this regard, the optical elements, such as the grating couplers, the superconducting stripes, and the nanophotonic waveguides, may be arranged on one side, i.e. the top side of the substrate, while the reception may be located on the other side, i.e. the bottom side of the same common substrate.

According to step (g) of the method for aligning an optical fiber array to a nanophotonic device, light, which may comprise single photons, is inserted from a selected optical fiber into a corresponding selected optical reference port of the nanophotonic device, wherein the selected optical fiber is to be aligned with the selected optical reference port. Herein, the selected optical reference port comprises an optical coupling to at least one of the other optical reference ports.

According to step (h) of the method for aligning an optical fiber array to a nanophotonic device, a transmission of the light within at least one optical fiber to be aligned with one of the other optical reference ports is detected. In a preferred embodiment, light inserted during step (g) via the single selected optical fiber into the selected optical reference port may, thus, be guided by the optical coupling to the other optical reference ports, wherein it may be detected simultaneously.

According to step (i) of the method for aligning an optical fiber array to a nanophotonic device, the transmission of the light within the optical fiber to be aligned with the other optical reference ports is increased by adjusting an orientation of the optical fiber array with respect to the substrate. Consequently, by increasing the transmission of the light within the optical fiber to be aligned with the other optical reference ports, the entire optical fibers comprised within the optical fiber array are automatically aligned to all grating couplers of the nanophotonic device. As a result, a scalable alignment of the nanophotonic device with respect to both its optical and electrical properties may be achieved in a rather simple manner, thus, providing highly reproducible results at low fabrication costs.

Summarizing, the present invention provides a single-photon camera comprising a number of segments, wherein each segment, located on a substrate, comprises a grating coupler, which is optically coupled, for example, by using a nanophotonic waveguide, to a superconducting stripe being capable of working near-unity efficiency and high performance. By employing segments which comprise superconducting single-photon detectors being coupled to a two-dimensional optical fiber array by using a grating coupling architecture, single-photon imaging over a broad wavelength range may become possible at high count rates with negligible false counts. A use of a common substrate as an integral optical platform in combination with superconducting stripes enables an implementation of a large single-photon pixel-array configured for long-term integration and imaging, even under extremely low-intensity conditions. Furthermore, a fiber-coupled architecture as described herein may enable remote imaging and sensing at a single-photon level.

For achieving this purpose, the present invention may combine three so-far distinct areas of research into a unified technology, i.e. nanophotonic waveguides, nanowire single-photon detectors, and two-dimensional optical fiber arrays. Hereby, the present invention may overcome known problems in contacting nanoscale objects, such as nanophotonic waveguides or single-photon detectors, with macroscopic optical input devices, such as optical fiber arrays, in a reliable fashion, thus, bridging a gap between applied research and industrial application. Consequently, the present invention may provide a solution for matching a nanofabricated photonic integrated chip comprising a plurality of small detector devices with a two-dimensional fiber array matrix comprising a plurality of input ports.

By using the solution according to the present invention, i.e. by employing an alignment to the optical fiber array by using optical reference ports being co-fabricated with the photonic circuitry, the optical fiber array may be precisely aligned to all single-photon pixels within a single step, thus, producing an efficient coupling between the optical input and the one- dimensional or two-dimensional detector matrix as provided in the nanophotonic device. Hereby, the way of manufacturing which employs a two-step fabrication process allows optimizing the respective process parameters for the two steps in a separate manner. As an example, the detector chip may be nanoprocessed without worrying about temperature constraints for fiber access. On the other hand, tailor-made optical input ports consisting of large arrays of optical fibers may be provided by employing the available toolbox for fiber pulling.

The nanophotonic device and the single-photon camera according to the present invention may be used in a wide range of applications, including but not limited to quantum technology, biological imaging, astronomy, long-distance telecommunication, quantum cryptography, and medical imaging. As an example, by choosing a fiber-coupled approach, each individual segment of a single nanophotonic device may be addressed individually, thus, providing a matrix which may be used as a large number of individual detectors performing separately.

This approach may particularly be applicable in the areas of telecommunication and secure quantum communication. As an example, in quantum communication each segment may be assigned to a separate quantum channel, thus, allowing an implementation of a scalable communication system with a high band width. Within this regard, the optical throughput may scale with the detector rate and the number of detectors, thus, being increased by many orders of magnitude compared to existing systems.

As a further example, in imaging applications, the single-photon camera according to the present invention may allow for an acquisition of an entire two-dimensional picture with one shot. By employing this device, a use of scanning techniques may be avoided, thus, considerably increasing the frame rate and the camera speed. In addition, two-dimensional imaging may allow for exploiting the ultra-low timing jitter of the SSPDs and, therefore, increasing the performance of single-photon cameras beyond the state of the art.

As a further example, the present invention may also be of interest for applications in astronomy and astrophysics, particularly because of a wide optical detection window as inherently provided by the SSPDs, ranging from wavelengths in the infrared spectral range via the visible spectral range to the ultra-violet spectral range. This feature may also be of interest for free-space optical communication where light is monitored which may be transported during the optical atmospheric windows.

### Short description of the Figures

Further optional features and embodiments of the invention will be disclosed in more detail in the subsequent description of preferred embodiments, preferably in conjunction with the dependent claims. Therein, the respective optional features may be realized in an isolated fashion as well as in any arbitrary feasible combination, as the skilled person will realize. The scope of the invention is not restricted by the preferred embodiments. The embodiments are schematically depicted in the Figures. Therein, identical reference numbers in these Figures refer to identical or functionally comparable elements.

In the Figures:
- Figure 1: shows a segment of a nanophotonic device, wherein a single grating coupler is optically coupled to a superconducting stripe of a superconducting single-photon detector via a nanophotonic waveguide;
- Figure 2: displays a preferred embodiment of a nanophotonic device according to the present invention, wherein nine grating couplers for receiving incident light are located on a substrate, wherein three of the grating couplers constitute optical reference ports;
- Figure 3: exhibits a segment of a two-dimensional matrix of superconducting single-photon detectors as arranged in a nanophotonic device according to the present invention together with the corresponding electrical circuits, wherein the optical reference ports are omitted for the sake of clarity;

- Figure 4: schematically depicts a single-photon detector chip comprising a nanophotonic device according to the present invention together with the respective wiring for integration into a housing of a single-photon camera.

### Detailed description of the embodiments

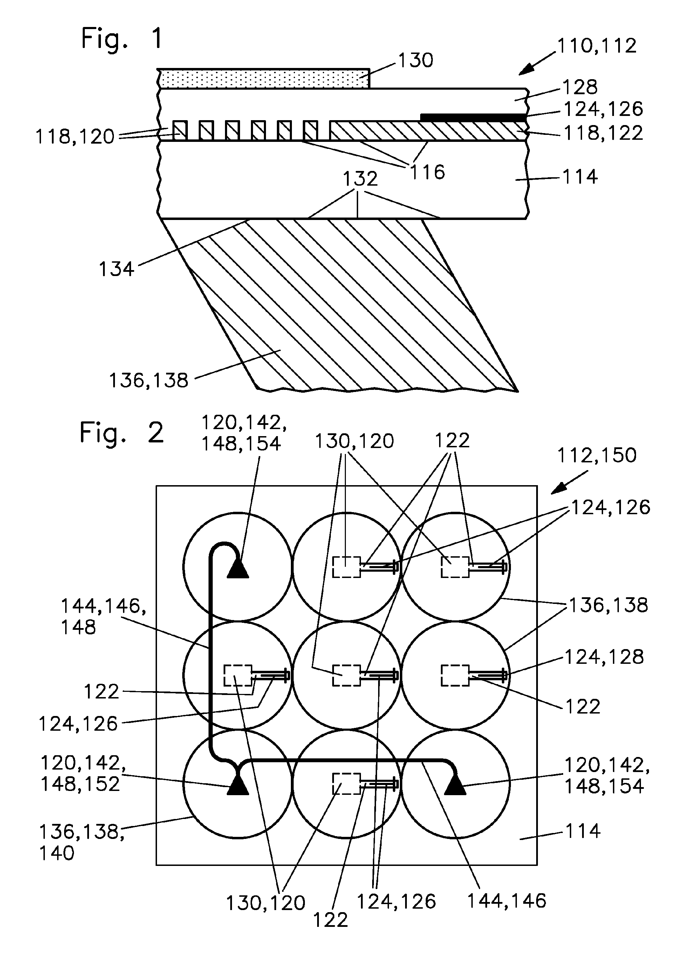

Figure 1 shows a segment 110 of a nanophotonic device 112 as a particularly preferred embodiment according to the present invention. The segment 110 of the nanophotonic device 112 as depicted in Figure 1 is located on a transparent substrate 114, for which purpose a flat plate of glass or quartz is preferred. In accordance with the present invention, on the top 116 of the transparent substrate 114 a thin film of a wide electronic bandgap material, preferably aluminum nitrite, gallium nitrite or silicon nitrite, is located. As further schematically shown in Figure 1, a grating coupler 120 is structured into an area of the wide-bandgap material 118 while a further area of the film of the wide-bandgap material 118 is structured as a nanophotonic waveguide 122, wherein the nanophotonic waveguide 122 optically couples the grating coupler 120 to a superconducting stripe 124 which constitutes an active element of a superconducting single-photon detector (SSPD) 126. For this purpose, a superconducting film, in particular comprising a superconducting material such as NbₓN, is placed on an area of the film of the wide-bandgap material 118, thus, being configured for receiving single photons, which are able to form a resistive region within the superconducting stripe 124. As a result, the corresponding superconducting single-photon detector 126 produces, upon photon absorption, a distinct voltage pulse comprising an amplitude of the order of approx. 1mV.

As further shown in Figure 1, the optical elements located on the top 116 of the transparent substrate 114, i.e. the grating coupler 120, the nanophotonic waveguide 122, and a superconducting stripe 124, are covered with a passivation layer 128. In this preferred embodiment, a passivation layer 128 which preferably comprises a transparent glass film, preferentially manufactures by using liquid glass, not only protects the optical elements of the nanophotonic device 112 against environmental influence but also helps to increase the efficiency of the grating coupler 120. In addition, on the passivation layer 128, particularly in the area above the grating coupler 120, a reflecting layer 130 is placed in order to function as a high-reflectivity mirror which may force light being transmitted through the grating coupler 120 to be reflected back by the reflecting layer 130 into the grating coupler 120. For this purpose, a thin metallic film, such as a thin film of gold, is particularly suitable to achieve, thus, a nearly perfect coupling efficiency close to 100%.

Furthermore, the transparent substrate 114 comprises a bottom 132, which may be polished in order to achieve a desired thickness of the transparent substrate 114, and which further comprises a reception 134 for receiving an optical fiber 136, wherein the optical fiber 136 is part of an optical fiber 138 which comprises at least four optical fibers 136, are generally a multitude or a plurality, of optical fibers 136, wherein preferably each optical fiber 136 is to be aligned with a respective grating coupler 120 within the nanophotonic device 112. For this purpose, an orientation of the optical fiber array 138 with respect to the bottom 132 of the transparent substrate 114 is adjusted by increasing the transmission of the light as provided by the optical fiber 136 to the grating coupler 120. A preferred procedure for providing an alignment of the optical fiber array 138 to the nanophotonic device 112 will be described below in more detail.

With regard to the nanophotonic device 112, it is explicitly mentioned that the terms "top" 116 of the substrate 114 and the term "bottom" 132 of the substrate 114 only refer to opposing sides of the flat plate which constitutes the transparent substrate 114. Consequently, the nanophotonic device 112 according to the present invention is configured to function in any relative orientation with respect to the environment where, for example, a field of gravity may be present which defines a specific orientation which, however, is in no relationship with the mentioned terms "top" 116 and "bottom" 132.

Figure 2 shows a schematic top view of a preferred embodiment of the nanophotonic device 112. As depicted here, an optical fiber array 138 which comprises nine separate optical fibers 136 can be seen through the transparent substrate 114. Herein, each of the optical fibers 136 of the optical fiber array 138 are aligned with a corresponding grating coupler 120 of the nanophotonic device. However, as a result of the top view, the reflecting layers 130 hide the grating couplers 120 which are optically coupled by the nanophotonic waveguides 122 to the superconducting stripes 124 of the superconducting single-photon detectors 126. Therefore, only those grating couplers 120 are visible which constitute an optical reference port 142. According to the present invention, an optical coupling 144, preferably in the form of a nanophotonic waveguide 146, is provided between two of the optical reference ports 142. In the arrangement according to Figure 2, the optical reference ports 142 are located in three of the four corners 148 of the two-dimensional matrix 150, wherein, in this particular example, the two-dimensional matrix 150 comprises six separate superconducting stripes 124 as active elements of six superconducting single-photon detectors 126 and three grating couplers 120, wherein each grating coupler 120 constitutes an optical reference port 142 to be employed as alignment coupler.

In an alternative embodiment (not depicted here), the grating couplers 120 as optically coupled to the superconducting stripes 124 of the superconducting single-photon detectors 126 may be arranged in a single line, wherein each single line may be finalized by a grating coupler 120 which constitutes an optical reference port 142, thus, generating a one-dimensional matrix of crating couplers 120 on the substrate 114. This embodiment opens the possibility for providing a line detector of SSPDs.

Irrespective whether the grating couplers 120 are arranged in form of a one-dimensional matrix, a two-dimensional matrix 150, or in any other arrangement on the transparent substrate 114, the aligning of the optical fiber array 138 to the arrangement of the grating couplers 120 is preferably performed according to the following alignment procedure which comprises the alignment steps (f) to (i) as described above. For this purpose, according to step (f), the optical fiber array 138 is provided at a reception 134 at the bottom 132 of the transparent substrate 114 of the nanophotonic device 112. According to step (g), light is inserted from the selected optical fiber 140 into a selected optical reference port 152 of the nanophotonic device 112. Herein, the selected optical fiber 140 is to be aligned with the selected optical reference port 152. For this purpose, the selected optical reference port 152 comprises the optical coupling 144, preferably implemented by using a nanophotonic waveguide 146, to the two other optical reference ports 154. According to step (h), a transmission of the light within the optical fibers 136 of the optical fiber array 138 which are to be aligned with the other optical reference ports 154 is detected. In order to achieve a good alignment of the optical fiber array 138 to the nanophotonic device 112, the transmission of the light is, according to step (i), increased within the optical fibers 136 to be aligned with the other optical reference ports 154 by adjusting the orientation of the optical fiber array 138 with respect to the transparent substrate 114. By optimizing the transmission at the three corners 148 of the two-dimensional matrix 150, the entire optical fiber array 138 will be automatically aligned to all grating couplers 120 which are optically coupled to the superconducting stripes 124 of the SSPDs 126.

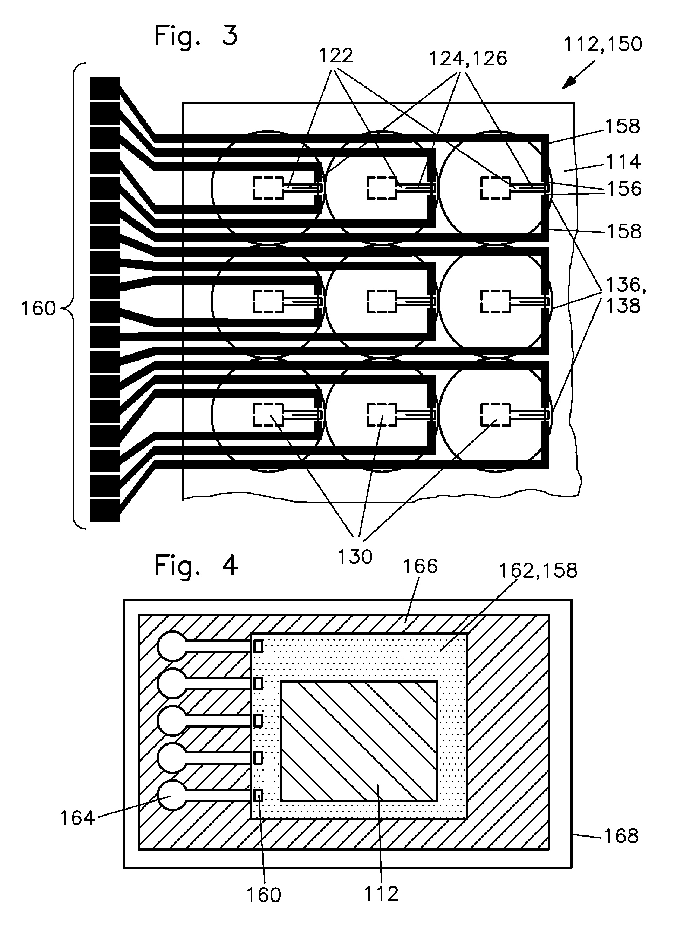

Figure 3 schematically shows a top view of a number of segments 110 of the nanophotonic device 112 wherein the optical reference ports 142 are omitted for the sake of clarity. Like in Figure 2, the reflecting layers 130 hide the grating couplers 120 optically coupled by nanophotonic waveguides 122 to superconducting stripes 124 of the superconducting single-photon detectors 126. Preferably, each superconducting stripe 124 comprises a structure which exhibits two ends functioning as electrodes 156, wherein each electrode 156 may be connected via an electrical contact 158 to one of a number of bond pads 160. For this purpose, flip-chip bonding may be employed for providing the electrical contacts 158 of the electrodes of the superconducting stripes 124 to the bond pads 160. This kind of procedure may be particularly advantageous since it comprises a known wafer-scale connection process to be employed on the electronic side, thus, allowing for a mass production and, simultaneously, avoiding pixel failure.

Figure 4 schematically depicts a single-photon detector chip which comprises the nanophotonic device 112 of the present invention equipped with electrical contacts 158 and a number of bond pads 160 which are connected to SMA (SubMiniature version A) connectors 164 or similar connectors as located on a board 166, such as PCB (printed circuit board) board or similar. The single-photon detector chip 162 may be preferably comprised within a housing 168 being configured for protecting the nanophotonic device 112 optically from stray light. In addition, the housing may further comprise a cool environment or may be inserted into a cool environment, such as a low-temperature cryostat, in particular for maintaining the temperatures as required for the operation of the SSPDs 126 as described above. In addition, the single-photon detector chip may be electrically or optically coupled to an evaluation unit (not depicted here), wherein electrical contacts and/or the output of the optical fiber array 138 may be used as a multi-port optical terminal or as an input to imaging optics as described above in further detail.

The detection performance of the nanophotonic device 112 may be determined by the performance of the individual SSPDs 126. Consequently, this may provide near-unity detection efficiency, count rates up to several GHz, dark count rates of sub-mHz and timing jitter below 20 ps. The grating couplers 120 according to the present invention may, thus, allow for a coupling efficiency approaching 100%, thereby achieving near 100% detection efficiency of each SSPD.

The optical fiber array 138 may comprise any type of optical fibers 136, in particular depending on the desired wavelength range. As an example, for applications in the infrared spectral range, chalcogenide fibers may be used since they are transparent for long wavelengths. Standard optical fibers may cover the entire telecommunications regime as well as visible wavelength and the near ultraviolet spectral range. If only near-infrared wavelengths are of interest, the single-photon detector chip may be placed on a silicon wafer connected to infrared fibers. This arrangement may also open a possibility for an integration of the single-photon detector chip 162 with CMOS electronics.

Summarizing, the nanophotonic device 112 and the single-photon detector chip 162 according to the present invention may allow implementing a single-photon imaging device, also denoted as a single-photon camera, with extremely low-noise equivalent power and high resolution. The scalable approach may, thus, allow integrating hundreds, thousands or more of SSPDs within a single device, thereby considerably reducing the production costs per detector. In addition, the running costs for a single-photon camera including the efforts for providing a cooling environment, may, therefore, also be reduced since only a single-photon detector chip needs to be operated at the same time. This has also the advantageous effect that uniform operation conditions may be provided for all SSPDs comprised within the nanophotonic device 112 in the single-photon detector chip 162 according to the present invention.

### List of reference numbers

- 110: segment
- 112: nanophotonic device
- 114: (transparent) substrate
- 116: top of the substrate
- 118: film of wide-bandgap material
- 120: grating coupler
- 122: nanophotonic waveguide
- 124: superconducting stripe
- 126: superconducting single-photon detector (SSPD)
- 128: passivation layer
- 130: reflecting layer
- 132: bottom of the substrate
- 134: reception
- 136: optical fiber
- 138: optical fiber array
- 140: selected optical fiber
- 142: optical reference port
- 144: optical coupling
- 146: nanophotonic waveguide
- 148: final position (comer)
- 150: two-dimensional matrix
- 152: selected optical reference port
- 154: other optical reference port
- 156: electrodes
- 158: electrical contact
- 160: bond pad
- 162: single-photon detector chip
- 164: (SMA) connector
- 166: (PCB) board
- 168: housing

## Claims

1. A nanophotonic device (112), comprising a transparent substrate (114), wherein at least four grating couplers (120) for receiving incident light are located on the substrate (114), wherein each of at least two of the grating couplers (120) are optically coupled to a superconducting stripe (124) of a superconducting single-photon detector (126), while each of at least two of the other grating couplers (120) constitute an optical reference port (142), wherein an optical coupling (144) is provided between at least two optical reference ports (142).

2. The nanophotonic device (112) according to the preceding claim, wherein the optical coupling (144) between the optical reference ports is provided by at least one nanophotonic waveguide (146).

3. The nanophotonic device (112) according to any one of the preceding claims, wherein the superconducting stripe (124) of the superconducting single-photon detector (126) is optically coupled to the grating coupler (120) by a further nanophotonic waveguide (122), wherein the further nanophotonic waveguide (122) is located on the substrate (114).

4. The nanophotonic device (112) according to any one of the preceding claims, wherein the grating couplers (120) on the substrate (114) are arranged in an arrangement selected from:
- at least two of the grating couplers (120) optically coupled to the superconducting stripes (124) and at least two of the grating couplers (120) which constitute the optical reference ports (142) being arranged as a one-dimensional matrix on the substrate (114); or
- at least three of the grating couplers (120) optically coupled to the superconducting stripes (124) and at least three of the grating couplers (120) which constitute the optical reference ports (142) being arranged as a two-dimensional matrix (150) on the substrate (114).

5. The nanophotonic device (112) according to the preceding claim, wherein the optical reference ports (142) are located at least one final position (148) in the arrangement.

6. The nanophotonic device (112) according to any one of the preceding claims, wherein the grating couplers (120) used as the optical reference ports (142) and the grating couplers (120) coupled to the superconducting stripes (124) are co-fabricated on the substrate (114).

7. The nanophotonic device (112) according to any one of the preceding claims, wherein at least the grating couplers (120) are covered with a passivation layer (128).

8. The nanophotonic device (112) according to the preceding claim, wherein a reflecting layer (130) is placed on the passivation layer (128) above the grating couplers (120) which are optically coupled to the superconducting stripe (124).

9. The nanophotonic device (112) according to any one of the preceding claims, wherein the substrate (114) further comprises a reception (134) for receiving an optical fiber array (138) of at least four optical fibers (136) for aligning each of the optical fibers (136) with one of the grating couplers (120).

10. A single-photon camera, comprising a housing (168), wherein the housing (168) comprises a single-photon detector chip (162), wherein the single-photon detector chip (162) comprises at least one nanophotonic device (112) according to any one of the preceding claims, wherein the single-photon detector chip (162) further comprises a reception (134) for receiving an optical fiber array (138) of at least four optical fibers (136) for aligning each of the optical fibers (136) with one of the grating couplers (120) of the nanophotonic device (110).

11. A method for manufacturing a nanophotonic device (112), comprising the following manufacturing steps:
(a) providing a transparent substrate (114);
(b) depositing a film of a wide-bandgap material (118) onto the substrate (114);
(c) placing a superconducting film on a part of the wide-bandgap material (118) in form of a superconducting stripe (124) for a superconducting single-photon detector (126);
(d) structuring at least four grating couplers (120) into the wide-bandgap material (118) outside the area where the superconducting film is placed on the wide-bandgap material (118) in a manner that each of at least two of the grating couplers (120) are optically coupled to the superconducting stripe (124); and
(e) providing an optical coupling (144) between at least two other of the grating couplers (120), wherein each of at least two of the other grating couplers (120) constitute an optical reference port (142).

12. The method according to the preceding claim, wherein at least one nanophotonic waveguide (146) is provided for the optical coupling (144) between the optical reference ports (142).

13. The method according to any one of the preceding method claims, wherein a further nanophotonic waveguide (122) is structured into the wide-bandgap material (118) for optically coupling each of the at least two of the grating couplers (120) to the superconducting stripe (124).

14. The method according to any one of the preceding method claims, wherein a passivation layer (128) is deposited for covering at least the grating couplers (120), wherein a reflecting layer (130) is preferably placed on the passivation layer (130) in an area located above the grating couplers (120) which are optically coupled to the superconducting stripe (124).

15. A method for aligning an optical fiber array (138) to a nanophotonic device (112) according to any one of the preceding claims referring to the nanophotonic device (112), comprising the following alignment steps:
(f) providing the optical fiber array (138) for a reception (134) at the substrate (114) of the nanophotonic device (112);
(g) inserting light from a selected optical fiber (140) into a selected optical reference port (152) of the nanophotonic device (110), wherein the selected optical fiber (140) is to be aligned with the selected optical reference port (152), wherein the selected optical reference port (152) comprises an optical coupling (144) to at least one of the other optical reference ports (154);
(h) detecting a transmission of the light within at least one optical fiber (136) to be aligned with one of the other optical reference ports (154); and
(i) increasing the transmission of the light within the optical fiber (136) to be aligned with the other optical reference ports (154) by adjusting an orientation of the optical fiber array (138) with respect to the substrate (114).
